# Europäisches Patentamt
## European Patent Office
## Office européen des brevets

(19)

(11) Veröffentlichungsnummer: **0 144 923**
**B1**

(12)

# EUROPÄISCHE PATENTSCHRIFT

(45) Veröffentlichungstag der Patentschrift:
24.02.88

(51) Int. Cl.⁴: **H 05 K 7/14**

(21) Anmeldenummer: **84114502.2**

(22) Anmeldetag: **29.11.84**

(54) Frontplatten-Einbaubaugruppe für eine Leiterplatte.

(30) Priorität: **03.12.83 DE 3343764**
**14.06.84 DE 8417989 U**
**31.08.84 DE 3432048**

(43) Veröffentlichungstag der Anmeldung:
**19.06.85 Patentblatt 85/25**

(45) Bekanntmachung des Hinweises auf die Patenterteilung:
**24.02.88 Patentblatt 88/8**

(84) Benannte Vertragsstaaten:
**AT BE CH DE FR GB LI NL**

(56) Entgegenhaltungen:
**DE-A-2 041 065**
**DE-A-2 300 215**
**DE-A-2 534 549**
**DE-A-2 714 409**
**DE-A-3 016 509**
**FR-A-1 336 881**
**US-A-3 154 631**
**US-A-4 225 209**
**US-A-4 397 513**

(73) Patentinhaber: **MENTOR Ing. Dr. Paul Mozar, Otto-Hahn- Strasse 1, D-4006 Erkrath- Unterfeldhaus (DE)**

(72) Erfinder: **Weyer, Erhard, Dr., Meissener Strasse 3, D-4000 Düsseldorf (DE)**
Erfinder: **Züchner, Werner, Kurpfalzstrasse 8, D-6940 Weinheim- Lützelsachsen (DE)**

(74) Vertreter: **Dipl.- Ing. H. Marsch Dipl.- Ing. K. Sparing Dipl.- Phys.Dr. W.H. Röhl Patentanwälte, Rethelstrasse 123, D-4000 Düsseldorf (DE)**

EP 0 144 923 B1

## Beschreibung

Die Erfindung betrifft eine Frontplatten-Einbaubaugruppe für eine Leiterplatte mit einem Träger, der Verbindungskontakte zum Verbinden des Trägers an der Leiterplatte aufweist, die in einem ersten vorbestimmten Raster angeordnet sind, sowie mit Gehäusen zur Aufnahme von Funktionsteilen, deren Gehäusekontakte entsprechend einem zweiten vorbestimmten Raster angeordnet sind sowie über in dem zweiten Raster angeordnete Kontaktsteckverbindungen mit den Verbindungskontakten lösbar in Eingriff stehen.

Eine derartige Frontplatten-Einbaubaugruppe ist aus der DE-A-3016 509 bekannt. Sie besitzt als kontaktstiftträger eine genormte Steckerleiste, in der Kontaktstifte entsprechend einem vorbestimmten Raster angeordnet sind, sowohl bodenseitig als auch frontseitig aus der Steckerleiste herausragen, wo sie innerhalb einer rahmenartigen Umfassungsleiste angeordnet sind. Gehäuse mit Funktionselementen wie Anzeige- und Bedienungselemente, die entsprechende Buchsen für die frontseitigen Kontaktstiftenden der Steckerleiste aufweisen, können dann aufgesteckt werden. Hierbei ist jedoch die Stekkerleiste mit den herausragenden Kontaktstiften in die Leiterkarte einzustecken und dann zu verlöten, wobei die Steckerleiste an allen Rasterpunkten mit den Kontaktstiften zu versehen ist, was beides sehr aufwendig ist und einen großen Platzbedarf auf der Leiterplatte zur Folge hat, zumal wenn nur eine begrenzte Zahl von Funktionselementen eingesetzt werden soll.

Aufgabe der Erfindung ist es, eine Frontplatten-Einbaubaugruppe der eingangs genannten Art zu schaffen, die mit den nötigen Verbindungskontakten in einfacher Weise bestückt und mit der Leiterplatte verbunden werden kann.

Diese Aufgabe wird dadurch gelöst, daß der Träger als Adapter ausgebildet ist und die Verbindungskontakte L-förmig und im Adapter mit ihren mit den Gehäusekontakten in Eingriff bringbaren Schenkeln entgegen der Richtung der Krafteinwirkung von der Leiterplatte her abgestützt sind, wobei die Gehäuse entsprechend dem zweiten Raster standardisiert und die Verbindungskontakte in den Adapter nach Bedarf einbringbar sind, während der Adapter entsprechend dem zweiten Raster angeordnete Einsecköffnungen aufweist, die die Kontaktsteckverbindungen bildenden Schenkel der Verbindungskontakte aufnehmen.

Eine derartige Einbaugruppe eignet sich insbesondere für Hinterfrontbauelemente und ermöglicht eine Vorfertigung und gleichzeitig damit auch eine Vorprüfung der Baugruppe vor dem Montieren auf einer Leiterplatte. Die Verbindungskontakte können in einfacher Weise je nach Bedarf von der Rückseite des Adapters her in diesen eingesteckt werden und sind derart angeordnet und abgestützt, daß sie sicher gehalten und in einfacher Weise mit der Leiterplatte verbunden werden können. Die Gehäuse für die Funktionselemente sind gegenüber dem Adapter gesichert und justiert, falls sie nicht gleich einstückig mit dem Adapter ausgebildet sind.

Weitere Ausgestaltungen der Erfindung sind den Unteransprüchen und der nachfolgenden Beschreibung zu entnehmen.

Die Erfindung wird nachstehend anhand der in den beigefügten Abbildungen dargestellten Ausführungsbeispielen näher erläutert.

Fig. 1 zeigt eine Frontansicht eines Ausführungsbeispiels einer Frontplatten-Einbaubaugruppe.

Fig. 2 zeigt eine Seitenansicht der Baugruppe von Fig. 1.

Fig. 3 zeigt den Adapter der Baugruppe von Fig. 1 im Schnitt.

Fig. 4 zeigt einen Zusatzadapter für die Baugruppe von Fig. 1.

Fig. 5 zeigt im Schnitt eine weitere Ausführungsform eines Adapters einer Frontplatten-Einbaubaugruppe.

Fig. 6 zeigt den Adapter von Fig. 5 in Frontansicht.

Fig. 7 zeigt eine alternative Ausführungsform für einen Verbindungskontakt für den Adapter von Fig. 5.

Fig. 8 zeigt eine Frontplatten-Einbaubaugruppe im Vertikalschnitt.

Fig. 9 zeigt die Einbaubaugruppe von Fig. 8 in rückseitiger Ansicht.

Fig. 10 zeigt die Einbaubaugruppe von Fig. 8 in Draufsicht und teilweise geschnitten.

Fig. 11 zeigt ausschnittweise eine andere Ausführungsform einer Einbaubaugruppe im Vertikalschnitt.

Fig. 12 und 13 zeigen zwei Ausführungsformen einer Einbaubaugruppe aus übereinander gestapelten Elementen im Schnitt.

Fig. 14 zeigt eine Frontansicht einer besonders flachen Einbaubaugruppe.

Fig. 15 zeigt die Einbaubaugruppe von Fig. 14 in Draufsicht, teilweise geschnitten.

Fig. 16 zeigt eine Rückansicht der Einbaubaugruppe von Fig. 14.

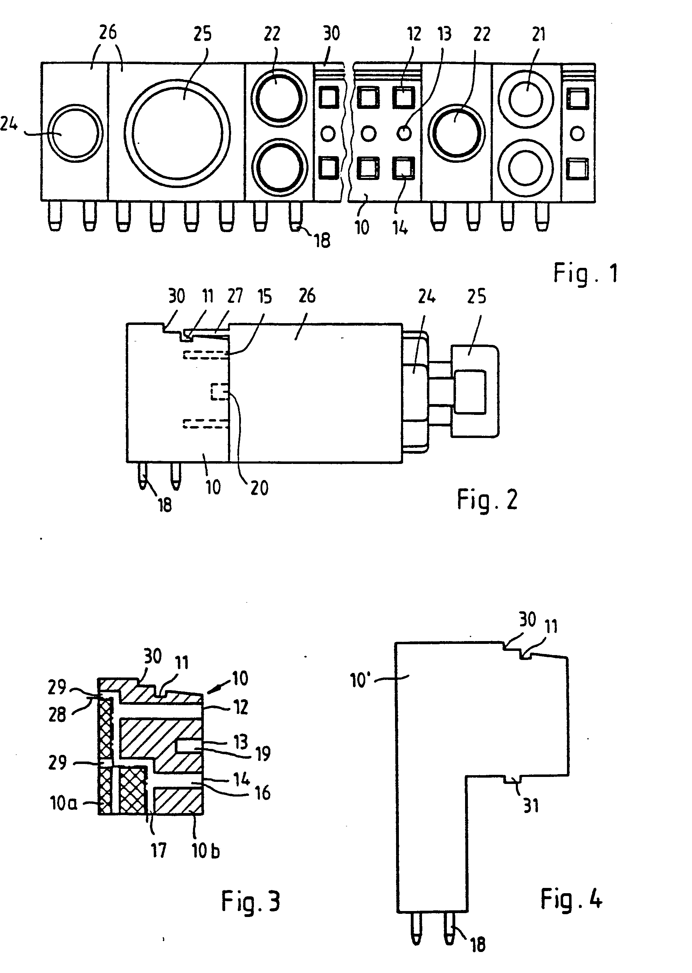

Die Frontplatten-Einbaubaugruppe der Fig. 1 bis 3 umfaßt einen Adapter 10, der im wesentlichen quaderförmig ist und an seiner Oberseite eine sich über die Länge des Adapters 10 erstreckende Nut 11 aufweist, die mit Abstand zur vorderseitigen Oberkante angeordnet ist. Der Bereich von der Nut 11 zur benachbarten Vorderkante ist abgeschrägt.

Zweckmäßigerweise weist der Adapter 10 frontseitig in drei übereinander liegenden parallelen Reihen eine Vielzahl von Öffnungen 12, 13, 14 auf, die rasterförmig mit äquidistantem Abstand in Längsrichtung des Adapters 10 angeordnet sind. Dabie bilden die oberen und unteren Öffnungen 12 und 14 Buchsen zur Aufnahme von Steckkontakten 15, indem sich von den Öffnungen 12 und 14 Kanäle 16 parallel zur Bodenseite des Adapters 10 in diesen hinein erstrecken, die in Kanälen 17 münden, die an der Bodenseite des Adapters 10 enden und parallel zur Frontseite hiervon verlaufen. In die jeweiligen Kanäle 16, 17 können je nach Bedarf Kontaktstifte 18 eingesetzt werden, die winkelförmig sind und deren Kontaktfedern (nicht dargestellt) von den Kanälen 16 aufgenommen werden. Die aus dem Adapter 10 herausragenden Enden der Kontaktstife 18, deren Rasteranordnung der Rasteranordnung der Einstecklöcher entsprechender Leiterplatten entspricht, können in den entsprechenden Einstecklöchern einer Leiterplatte durch Einpressen befestigt werden, da sie mit ihrem in dem Kanal 16 befindlichen Schenkel durch den Adapter 10 entgegen der Einpreßrichtung abgestützt werden.

Die zwischen zwei übereinander befindlichen Öffnungen 12, 14 befindlichen Öffnungen 13 sind die Mündungen von Sacklöchern 19, die zur Aufnahme von Zapfen 20 dienen.

Funktionselemente wie Schalt- oder Prüfbuchsen 21, LED's 22, Drucktaster 24, Druckschalter 25, Potentiometer oder sonstige Einstellorgane, Zählwerke oder dergleichen sind in standardisierten Gehäusen 26 angeordnet, deren Breite einem Vielfachen des Rastermaßes der Öffnungen 12, 13, 14 in Längsrichtung und deren Höhe der Höhe des Adapters 10 entspricht, während ihre Tiefe gleich ist.

Insbesondere ist eine Einrichtung zum Justieren der Gehäuse 26 gegenüber dem Adapter 10 entsprechend dem Raster der Öffnungen 12, 14 vorgesehen. Hierzu können die Gehäuse 26 rückseitig wenigstens einen Zapfen 20 entsprechend der Rasterung der Öffnungen 13 zum Einstecken in diese sowie die erforderliche Anzahl von Steckkontakten 15 entsprechend der Rasterung der Öffnungen 12, 14 besitzen. Außerdem besitzen die Gehäuse 26 an ihrer Rückseite eine sich über deren Länge erstreckende Federzunge 27, die mit ihrem hakenförmigen Ende in die Nut 11 eingreift, um als Transportsicherung für die Gehäuse 26 zu dienen. Die Abschrägung zwischen der vorderseitigen Oberkante und der Nut 11 des Adapters 10 dient beim Anbringen eines Gehäuses 26 an dem Adapter 10 zur Auslenkung der Federzunge 27, bis deren hakenförmige Endkante in die Nut 11 einrasten kann.

Anstelle der Federzunge 27 und gegebenenfalls der Zapfen 20 können auch andere lösbare Rastverbindungen zum Befestigen und Justieren der Gehäuse 26 an der Frontseite des Adapters 10 verwendet werden, jedoch wird die dargestellte Ausführungsform aus spritztechnischen Gründen bevorzugt.

Um den Adapter 10 auch gegebenenfalls mit der Frontseite nach oben auf eine Leiterplatte aufbringen zu können, sind die Kanäle 17 über die Kanäle 16 hinaus verlängert und mit Kanälen 29 verbunden, die auf der Rückseite des Adapters 10 münden und ebenfalls im Raster der Kanäle 17 bzw. der Einstecklöcher der Leiterplatte angeordnet sind. Durch die Verlängerung der Kanäle 17 stützen sich aus den Kanälen 29 herausragende Kontaktstifte ebenfalls im Adapter 10 ab und können daher mittels Preßtechnik an der Leiterplatte befestigt werden. Der Adapter 10 kann sich über die gesamte Breite einer Frontplatte erstrecken, was insbesondere dann vorteilhaft ist, wenn auf der gesamten oder nahezu gesamten Frontplattenbreite auch Gehäuse mit Funktionselementen unterzubringen sind. Es kann aber auch zweckmäßig sein, den Adapter 10 nur in einer Breite entsprechend der von nur einem oder zwei Gehäusen - also dann mit vier Kontaktstiften - auszubilden; die Frontplattenbreite kann dann je nach Bedarf mit solchen Einzeladaptern in Aneinanderreihung ausgefüllt werden oder auch mit Blindstücken, wo keine Gehäuse mit Funktionselementen vorzusehen sind.

Der Adapter 10 der Ausführungsform der Fig. 1 bis 3 besteht vorzugsweise aus zwei Teilen 10a, 10b, die durch Ultraschallschweißen, Kleben oder lösbare oder unlösbare Steckverbindungen nach dem Einlegen der Kontaktstifte 18 miteinander verbunden werden. Die Trennlinie 28 zwischen den beiden Teilen 10a, 10b ist in Fig. 3 strichpunktiert dargestellt. Die Trennlinie 28 zwischen den beiden Teilen 10a, 10b verläuft entlang der Kanäle 17 und 29.

Die Kanäle 17 können auch untereinander durch sich in Längsrichtung des Adapters 10 erstreckende nicht dargestellt Kanäle verbunden sein, um bereits im Adapter 10 Kontaktverbindungen herstellen zu können. Solche Kontaktverbindungen sind dort zweckmäßig, wo bereits bekannt ist, welche Funktionselemente die anzubringenden Gehäuse aufweisen. Handelt es sich z. B. um eine Sieben-Segment-Anzeige, so kann die zugehörige Dekodierlogik im Adapter untergebracht werden, und man spart Platz auf der Leiterplatte. Dies ist nur ein Beispiel für verschiedene Standard- oder Spezialnetzwerke, die eine Anpassung zwischen der Schaltung auf der Leiterplatte einerseits und den Funktionselementen andererseits bewirken.

Der Adapter 10 kann durch weitere Adapter 10' vergrößert werden, zu welchem Zweck der Adapter 10 eine Stufe 30 aufweist, die sich an seiner Oberseite in Längsrichtung erstreckt und benachbart zu der Nut 11 angeordnet ist. Der Adapter 10' ist im wesentlichen L-förmig und umgreift den Adapter 10 an der Ober- und Rückseite. An dem die Oberseite des Adapters 10 übergreifenden Schenkel des Adapters 10' ist an der Unterseite eine Rippe 31 angebracht, die beim Aufschieben des Adapters 10' auf den Adapter 10 mit dessen Stufe 30 in Eingriff gelangt und so für die Abstützung des Adapters 10' sorgt. Ansonsten ist der Adapter 10' im gleichen Raster entsprechend dem Adapter 10 ausgebildet, so daß er ebenfalls Gehäuse 26 aufnehmen kann. Gegebenenfalls können dann auch Gehäuse 26 doppelter Höhe verwendet werden, die dann mit ihren Steckkontakten 15 in beiden Adaptern 10, 10' stecken. Der Adapter 10' kann ebenfalls eine Stufe 30 an seiner Oberseite zur Sicherung eines weiteren den Adapter 10' übergreifenden Adapters aufweisen, der analog zum Adapter 10' aufgebaut ist, usw. Auf diese Weise können auf den Adapter 10, 10' Gehäuse 26 gleicher Tiefe angebracht werden, deren Rückseiten fluchten, während ihre Ober- und Unterseiten mit den Ober- und Unterseiten des Adapters 10 bzw. der Ober- und Unterseiten des den Adapter 10 überdeckenden Schenkels des Adapters 10' bzw. mit den Ober und Unterseiten der Adapter 10, 10' fluchten.

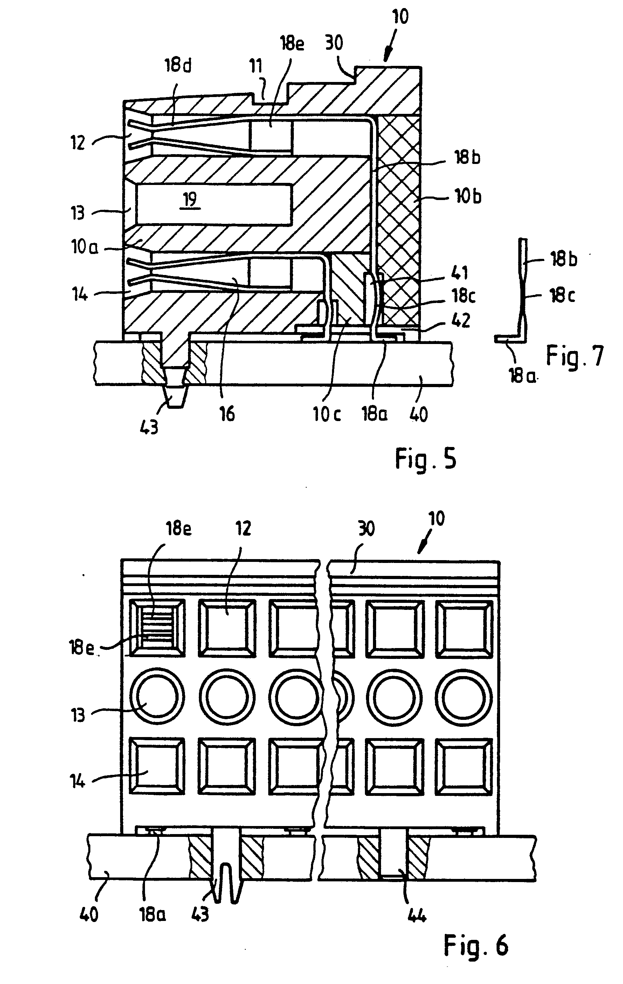

Der Fig. 5 und 6 dargestellte Adapter 10 unterscheidet sich von demjenigen der vorhergehenden Ausführungsform dadurch, daß die Verbindungskontakte 18 solche sind, die sich zur Oberflächenmontierung auf einer Leiterplatte 40 eignen. Zu diesem Zweck sind die aus dem Adapter 10 herausragenden Enden der Verbindungskontakte 18 mit Füßen 18a versehen, so daß eine Verbindung nach der OMB-Technik erfolgen kann, d.h. daß die Füße 18a mit der Leiterplatte 40 verklebt und anschließend durch Einwirkung eines Heißluftstroms verlötet werden, wobei die Füße 18a bereits das Lötmaterial tragen. Stattdessen kann aber auch ein Leitkleben oder dergleichen erfolgen.

Die Verbindungskontakte 18 sind vorzugsweise bezüglich des den Fuß 18a tragenden Schenkels 18b elastisch, um ein sicheres Andrücken an die Leiterplatte 40 zu ermöglichen. Hierzu ist beispielsweise benachbart zu dem Fuß 18a ein elastischer Abschnitt 18c in Form einer Ausbiegung oder Ausknickung (Fig. 5) oder einer Verjüngung der Stärke des Verbindungskontaktmaterials (Fig. 7) vorgesehen. Der elastische oder federnde Abschnitt 18c ist dabei vorzugsweise in einer Ausnehmung 41 benachbart zum Fuß 18a angeordnet, die breit genug ist, um die elastische Verformung des Schenkels 18b aufzunehmen.

Zur Zuführung eines Heißluftstroms zum Verlöten der Füße 18a mit der Leiterplatte 40 ist zweckmäßigerweise ein Zuführkanal 42 an der Unterseite des Adapters 10 im Bereich der Füße 18a vorgesehen, der sich praktisch über die gesamte Breite des Adapters 10 erstreckt.

Um einen gleichbleibenden Federdruck der Füße 18a auf die Leiterplatte 40 beim Löten sicherzustellen, können an der Unterseite des Adapters 10 Schnappfüße 43 vorgesehen sein, die geschlitzt ausgeführt und durch entsprechende Löcher in der Leiterplatte 40 steckbar sind, so daß sich ihre freien Enden aufspreizen und den Adapter 10 gegenüber der Leiterplatte 40 durch ihre Schnappwirkung verriegeln. Zusätzlich können Zapfen 44 zum Positionieren des Adapters 10 auf der Leiterplatte 40 vorgesehen sein.

Wie bei der vorhergehenden Ausführungsform besitzen die Verbindungskontakte 18 in den Öffnungen 16 befindliche Federzungen 18d, die paarweise über ein Verbindungsstück 18e miteinander verbunden sind.

Der Adapter 10 gemäß den Fig. 5 und 6 besteht vorzugsweise aus drei Teilen 10a, 10b und 10c, wobei die Trennungslinien zumindest teilweise entlang der die Verbindungskontakte 18 aufnehmenden Kanäle verlaufen. Auch hier können weitere Adapter 10' zur Vergrößerung verwendet und an der Rückseite des Adapters 10 endende Kanäle zur Aufnahme der Verbindungskontakte 18 vorgesehen werden, damit der Adapter 10 auch mit seiner Rückseite auf der Leiterplatte 40 befestigt werden kann. Auch können im Adapter 10 bereits Kontaktverbindungen, wie vorstehend erläutert, vorgesehen sein.

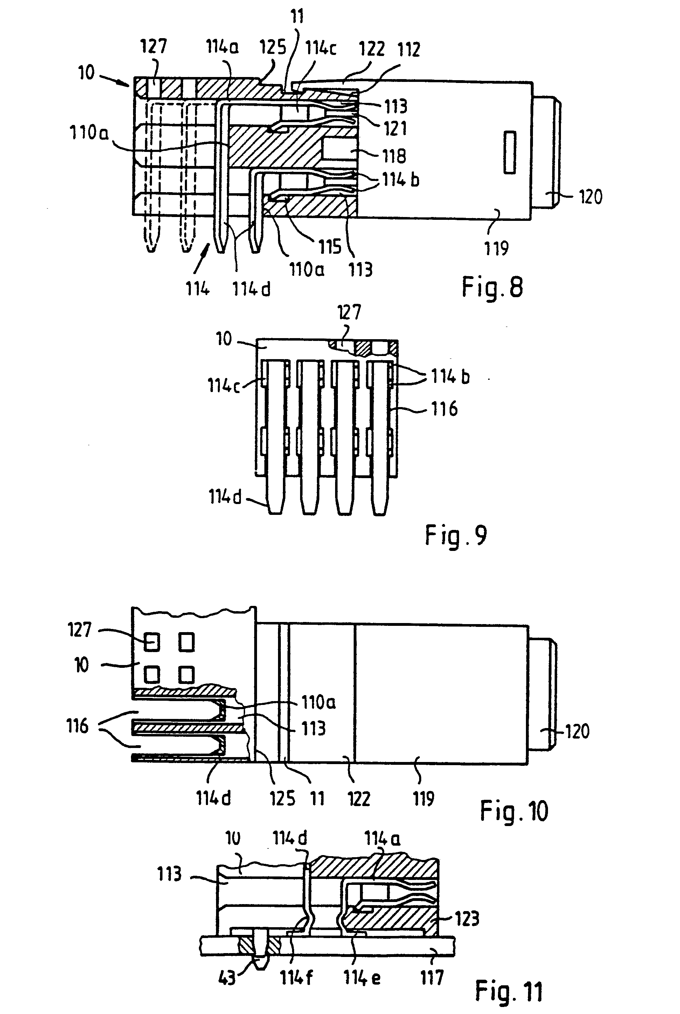

Die Frontplatten-Einbaubaugruppe der Fig. 8 bis 10 umfaßt einen Adapter 10, der im wesentlichen quaderförmig ist und an seiner Oberseite eine sich über die Länge des Adapters 10 erstreckende Nut 11 aufweist, die mit Abstand zur vorderseitigen Oberkante angeordnet ist. Der Bereich 112 von der Nut 11 zur benachbarten Vorderkante ist abgeschrägt. Der Adapter 10 besitzt in zwei übereinander liegenden parallelen Reihen eine Vielzahl von in einem vorbestimmten Raster angeordneten, frontseitig mündenden Einstecköffnungen 113, die jeweils einen Schenkel 114a eines Lförmig ausgebildeten Kontaktstiftes 114 aufnehmen können, wobei der Schenkel I14a als Kontaktsteckverbindung ausgebildet ist. Zu diesem Zweck besitzt der Schenkel 114a Kontaktfedern 114b, die durch eine Brücke 114c miteinander verbunden sind, wobei eine Kontaktfeder 114b mit ihrem hinteren abgewinkelten freien Ende jeweils in einer Ausnehmung 115, die in der entsprechenden Einstecköffnung 113 mündet, abgestützt sein kann. Einführschlitze 116 für die Kontaktstifte 114 erstrecken sich von der Rückseite des Adapters 10 her einwärts und von dessen Bodenseite her aufwärts bis zu den Einstecköffnungen 113, in denen sie münden. Wie aus Fig. 8 ersichtlich, können die Kontaktstifte 114 in die Einführschlitze 116 nach Bedarf von der Rückseite des Adapters 10 her eingeführt werden, bis sie mit ihren sich zu einer Leiterplatte erstreckenden Schenkeln 114d, die senkrecht zu den Schenkeln 114a angeordnet sind, gegen die Einführschlitze 116 einwärts begrenzenden Anschlagschultern 110a stoßen. Die Einführschlitze 116 sind, wie aus Fig. 8 ersichtlich ist, gestuft, so daß die Schenkel 114d der unteren Reihe von Kontaktstiften 114 mit den Schenkeln 114d der oberen Reihe von Kontaktstiften 114 in einem vorbestimmten Raster angeordnet werden. Die aus dem Adapter 10 herausragenden Enden der Kontaktstifte 114, deren Rasteranordnung der Rasteranordnung der Einstecklöcher entsprechender Leiterplatten 117 entspricht, können in den entsprechenden Einstecklöchern einer derartigen Leiterplatte 117 durch Einpressen befestigt werden, da sie mit ihrem in der jeweiligen Einstecköffnung 113 befindlichen Schenkel 114a durch den Adapter 10 entgegen der Einpreßrichtung abgestützt werden.

Zwischen zwei übereinander befindlichen Einstecköffnungen 113 besitzt der Adapter 10 jeweils frontseitig mündende Sacklöcher zur Aufnahme von Zapfen 118, die sich rückseitig von Gehäusen 119 befinden. Die Gehäuse 119, deren Tiefe vorzugsweise einheitlich und deren Höhe gleich der Höhe des Adapters 10 oder eines Vielfachen hiervon ist, während die Breite der Gehäuse 119 wenigstens das Zweifache des Rastermaßes der Einstecköffnungen ist, nehmen Funktionselemente 120 auf, z. B. Schalt- oder Prüfbuchsen, LED's, Drucktaster, Druckschalter, Potentiometer oder sonstige Einstellorgane, Zählwerke oder dergleichen. Die Gehäuse 119 sind vorzugsweise in der aufgeführten Weise standardisiert. Rückseitig besitzen die Gehäuse 119 Zapfen 118 entsprechend der Rasterung der Einstecköffnungen 113 sowie die erforderliche Anzahl an Steckkontakten 121 entsprechend der Rasterung der Einstecköffnungen 113 angeordnet, so daß das Gehäuse 119 mit den Steckkontakten 121 in die Kontaktsteckverbindungen, die durch die Schenkel 114a der Kontaktstifte 114 gebildet werden, einsteckbar ist, wobei gleichzeitig die Zapfen 118, die in die entsprechenden Sacklöcher im Adapter 10 eingesteckt werden, zum Justieren der Gehäuse 119 dienen.

Außerdem besitzen die Gehäuse 119 an ihrer Rückseite eine sich über deren Länge erstreckende Federzunge 122, die mit ihrem hakenförmigen Ende in die Nut 11 eingreift, um als Transportsicherung für die Gehäuse 119 zu dienen. Die Abschrägung 112 zwischen der frontseitigen Oberkante des Adapters 10 und der Nut 11 dient beim Anbringen eines Gehäuses 119 an dem Adapter 10 zur Auslenkung der Federzunge 122, bis deren hakenförmige Endkante in die Nut 11 einrasten kann.

Die Einführungsöffnungen 113 sind bei dem dargestellten Ausführungsbeispiel im Schnitt im wesentlichen quadratisch und etwas breiter als die Breite der Schlitze 116, wobei der Schenkel 114a im wesentlichen allseitig abgestützt wird, während der Schenkel 114d seitlich durch die die Schlitze 116 begrenzenden Wandungen des Adapters 10 sowie durch die entsprechende Anschlagschulter 110a abgestützt wird.

Gemäß Fig. 11 sind Verbindungskontakte 114 vorgesehen, die sich zur Oberflächenmontierung auf der Leiterplatte 117 eignen. Hierzu weisen die Verbindungskontakte 114 Füße 114e an dem sich zur Leiterplatte 117 erstreckenden Schenkel 114d auf, wobei vorzugsweise ferner ein elastischer Abschnitt 114f benachbart zu dem Fuß 114e vorgesehen ist, der die Form einer Ausbiegung oder Ausknickung oder einer Verjüngung besitzen kann. Derartige Verbindungskontakte 114 eignen sich zur Verbindung mit der Leiterplatte 117 nach der OMB-Technik, wobei die Füße 114e mit der Leiterplatte 117 verklebt und anschließend durch Einwirkung eines Heißluftstroms verlötet werden, wobei die Füße 114e bereits das Lötmaterial tragen. Stattdessen kann aber auch ein Leitkleben oder dergleichen erfolgen.

Zur Zuführung eines Heißluftstroms zum Verlöten der Füße 114e mit der Leiterplatte 117 ist vorzugsweise ein zusätzlicher Heißluftkanal vorgesehen, der sich über die gesamte Länge des Adapters 10 an dessen Unterseite erstreckt und front- und rückseitig durch jeweils eine Fußleiste 123 des Adapters 10 begrenzt wird.

Um einen gleichbleibenden Federdruck der Füße 114e auf der Leiterplatte 117 beim Löten sicherzustellen, können auch hier an der Unterseite des Adapters 10 Schnappfüße 43 vorgesehen sein. Zusätzliche können auch Zapfen zum Positionieren des Adapters 10 auf der Leiterplatte 117 vorgesehen sein.

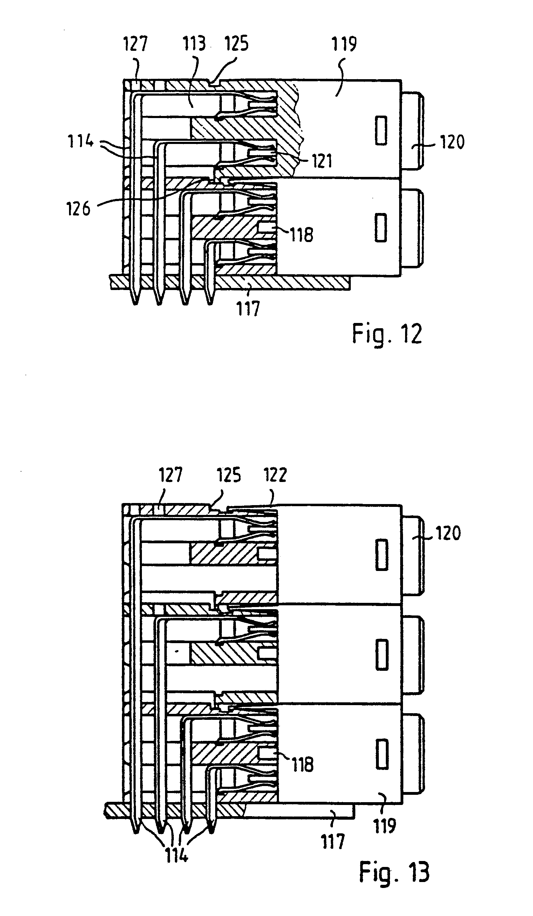

Die Adapter 10 sind vorzugsweise übereinander stapelbar ausgebildet und zu diesem Zweck an ihrer Oberseite mit einer sich in Längsrichtung des Adapters 10 erstreckenden Schulter 125 versehen, an der sich eine entsprechende Schulter 126 eines darüber gestapelten Adapters 10 abstützt. Die Adapter 10 sind entsprechend tief, so daß entsprechend dem Raster der Schenkel 114d der Kontaktstifte 114 Durchtrittsöffnungen 127 an der Oberseite des Adapters 10 vorgesehen werden können, die in entsprechenden Schlitzen 116 münden. Kontaktstifte 114 eines über einem Adapter 10 gestapelten Adapters 10' werden mit ihren Schenkeln 114d durch die Durchtrittsöffnungen 127 gesteckt und erstrecken sich bis zur Leiterplatte 117, wobei die Durchtrittsöffnungen 127 gleichzeitig zum allseitigen Abstützen der relativ langen Schenkel 114d dienen. Gegebenenfalls kommt man hierbei mit zwei zusätzlichen Reihen von Durchtrittsöffnungen 127 aus, wobei dann bei einer Anordnung der Adapter 10, 10' in drei Ebenen für die beiden oberen Ebenen nur einreihige Anschlüsse verwendet werden können, vgl. Fig. 13, während bei zwei Stapelebenen in jeder Ebene ein zweireihiges Anschließen möglich ist, vgl. Fig. 12.

Wie aus Fig. 12 ersichtlich, kann der Adapter 10 bzw. 10' auch einstükkig mit dem Gehäuse 119 ausgebildet sein, wobei dann die Schulter 125 eine seitliche Innenwandung einer Nut ist. Adapter 10 mit einstückigem Gehäuse 119 sowie Adapter 10 mit aufsteckbaren Gehäusen können neben- und übereinander verwendet werden. (Entsprechendes ist bei den Ausführungsformen der Fig. 1 bis 7 möglich.)

Die Verlängerung der Adapter 10 zur Anbringung der Durchtrittsöffnungen 127 ermöglicht ferner eine Anordnung der Kontaktstifte 114, wie sie in Fig. 8 gestrichelt dargestellt ist.

Anstatt Durchtrittsöffnungen 127 entsprechend dem Raster der Schenkel 114d vorzusehen, können auch L-förmige Adapter verwendet werden, die die Adapter 10 wie bei der Ausführungsform von Fig. 4 ober- und rückseitig übergreifen, jedoch ansonsten wie die Adapter 10 ausgebildet sind. Diese Anordnung kann auch über mehrere Ebenen erfolgen.

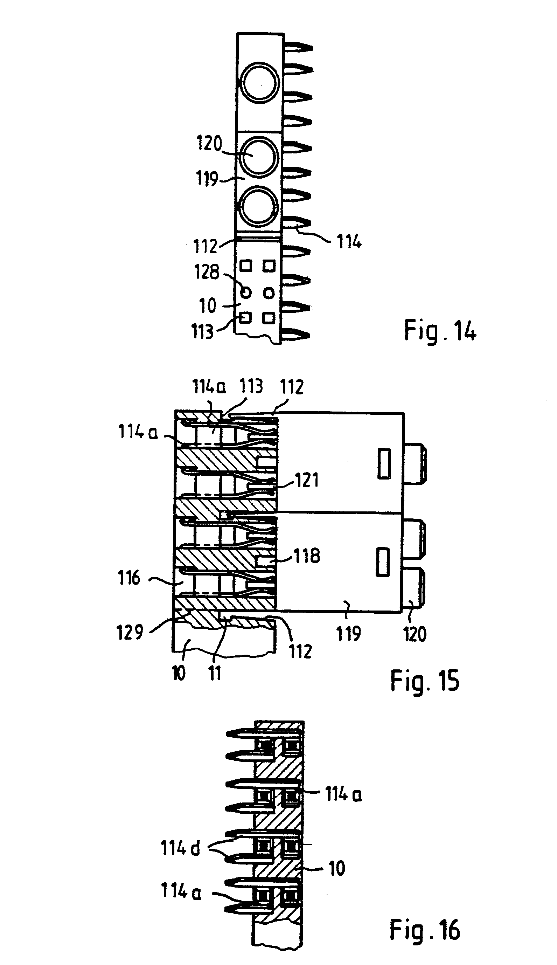

Bei der in den Fig. 14 bis 16 dargestellten Ausführungsform handelt es sich um einen Adapter 10 für Flachbauweise, bei dem nicht wie bei den vorhergehenden Ausführungsformen frontseitig zwei parallele Reihen von Einstecköffnungen 113 und eine hierzu parallele Reihe von Justierlöchern vorgesehen sind, die im gleichen Abstand wie die Einstecköffnungen angeordnet sind, wobei die Mittelpunkt der jeweils zu dritt in vertikalen Reihen angeordneten Öffnungen äquidistant zueinander angeordnet sind, sondern bei dem zwei parallele Reihen von äquidistanten Einstecköffnungen 113 vorgesehen sind, wobei jeweils nach zwei Paaren von Einstecköffnungen 113 einer Reihe ein Justierloch 128 für einen Zapfen 118 folgt.

Die Höhe dieses Adapters 10 ist derart bemessen, daß die gleichen Gehäuse 119 wie bei den vorhergehenden Ausführungsformen, jedoch um 90° gedreht verwendet werden, zu welchem Zweck sich entsprechende Einschnitte, die in den Nuten 11 münden und eine Anschrägung 112 aufweisen, von der Frontseite des Adapters 10 aus einwärts erstrecken. Diese nehmen die Federzungen 122 auf. Die Kontaktstifte 114 sind hierbei bodenseitig vom Adapter 10 nur in einer einzigen Reihe angeordnet, wobei jedoch die Einführschlitze 116 gegenüber den Einstecköffnungen 113 derart verbreitert sind, daß die Schenkel 114d der Kontaktstifte 114 der oberen Reihe entsprechend dem vorgesehenen Raster mit Abstand zu den Schenkeln 114d der Kontaktstifte 114 der unteren Reihe angeordnet werden können. Solche Adapter können auch korrespondierend zu denjenigen der Fig. 1 bis 7 oder auch einstückig mit dem Gehäuse 26 bzw. 119 ausgebildet sein.

Der Adapter kann mit Sollbruchstellen 129, wie in Fig.15 beispielhaft angedeutet, versehen werden, damit er je nach Bedarf in entsprechende Längen zerteilt werden kann.

Während zweckmäßigerweise die Tiefe der Gehäuse 26, 119 einheitlich ist, ist ihre Höhe gleich der Höhe des Adapters 10 oder eines Vielfachen hiervon, wobei die Breite der Gehäuse 26, 119 wenigstens das Zweifache des Rastermaßes der Kontaktsteckverbindung ist.

**Patentansprüche**

1. Frontplatten-Einbaubaugruppe für eine Leiterplatte (40, 117) mit einem Träger (10), der Verbindungskontakte (18, 114) zum Verbinden des Trägers (10) an der Leiterplatte (40, 117) aufweist, die in einem ersten vorbestimmten Raster angeordnet sind, sowie mit Gehäusen (26, 119) zur Aufnahme von Funktionselementen (21 bis 25, 120), deren Gehäusekontakte (15, 121) entsprechend einem zweiten vorbestimmten Raster angeordnet sind sowie über in dem zweiten Raster angeordnete Kontaktsteckverbindungen mit den Verbindungskontakten (18, 114) lösbar in Eingriff stehen, dadurch gekennzeichnet, daß der Träger als Adapter (10) ausgebildet ist und die Verbindungskontakte (18, 114) L-förmig und im Adapter (10) mit ihren mit den Gehäusekontakten (15, 121) in eingriff bringbaren Schenkeln (114a) entgegen der Richtung der Krafteinwirkung von der Leiterplatte (40, 117) her abgestützt sind, wobei die Gehäuse (26, 119) entsprechend dem zweiten Raster standardisiert und die Verbindungskontakte (18, 114) in den Adapter (10) nach Bedarf einbringbar sind, während Adapter (10) entsprechend dem zweiten Raster angeordnete Einstecköffnungen (16, 113) aufweist, die die Kontaktsteckverbindungen bildenden Schenkel (114a) der Verbindungskontakte (18, 114) aufnehmen.

2. Einbaubaugruppe nach Anspruch 1, dadurch gekennzeichnet, daß sich Einführschlitze (116) für die Verbindungskontakte (114) von der Rückseite des Adapters (10) her einwärts und von dessen Bodenseite her aufwärts bis zu den Einstecköffnungen (113) erstrecken.

3. Einbaubaugruppe nach Anspruch 1 oder 2, dadurch gekennzeichnet, daß die Einführschlitze (116) einwärts begrenzende Anschlagschultern (110a) Anschläge für die sich zur Leiterplatte (117) erstreckenden Schenkel (114d) der Verbindungskontakte (114) bilden.

4. Einbaubaugruppe nach Anspruch 1, dadurch gekennzeichnet, daß der Adapter (10) L-förmige Kanäle (16, 17) zur Aufnahme der Verbindungskontakte (18) besitzt.

5. Einbaubaugruppe nach Anspruch 4, dadurch gekennzeichnet, daß der Adapter (10) aus wenigstens zwei Teilen (10a, 10b, 10c) zusammengesetzt ist, wobei die Trennlinie zwischen den Teilen (10a, 10b, 10c) entlang der Kanäle (17) zur Aufnahme der sich zur Leiterplatte (40) erstreckenden Schenkel der Verbindungskontakte (18) verläuft.

6. Einbaubaugruppe nach Anspruch 4 oder 5, dadurch gekennzeichnet, daß die Kanäle (17) in dem Adapter (10) durch Kanäle (29), die an der Rückseite des Adapters (10) im Raster der Leiterplatte (40) enden, L-förmig verlängert sind.

7. Einbaubaugruppe nach einem der Ansprüche 1 bis 6, dadurch gekennzeichnet, daß das oder die Gehäuse (26, 119) einstückig mit dem Adapter (10) ausgebildet sind.

8. Einbaubaugruppe nach einem der Ansprüche 1 bis 6, dadurch gekennzeichnet, daß die Gehäuse (26, 119) mittels einer lösbaren Rastverbindung (11, 27; 11, 122) an dem Adapter (10) befestigbar sind.

9. Einbaubaugruppe nach Anspruch 8, dadurch gekennzeichnet, daß die lösbare Rastverbindung (11, 27; 11, 122) aus einer an der Rückseite des Gehäuses (26, 119) angeordneten Federzunge (27, 122) und einer an dem Adapter (10) angeordneten Nut (11), in die die Federzunge (27, 122) einrastbar ist, besteht.

10. Einbaubaugruppe nach Anspruch 9, dadurch gekennzeichnet, daß sich die Nut (11) in Längsrichtung des Adapters (10) an dessen Oberseite erstreckt.

11. Einbaubaugruppe nach Anspruch 9, dadurch gekennzeichnet, daß Nuten (11) zum Einrasten von Federzungen (122) in regelmäßigen Abständen entsprechend dem zweiten Raster senkrecht zur Längsrichtung des Adapters (10) frontseitig am Adapter (10) mündend angeordnet sind.

12. Einbaubaugruppe nach einem der Ansprüche 1 bis 11, dadurch gekennzeichnet, daß eine Einrichtung (20, 118) zum Justieren der Gehäuse (26, 119) gegenüber dem Adapter (10) entsprechend dem zweiten Raster vorgesehen ist.

13. Einbaubaugruppe nach einem der Ansprüche 8 bis 12, dadurch gekennzeichnet, daß die lösbare Rastverbindung (11, 27; 11, 122) und die Einrichtung (20, 118) zum Justieren vereinigt sind.

14. Einbaubaugruppe nach einem der Ansprüche 1 bis 3 und 7 bis 14, dadurch gekennzeichnet, daß der Adapter (10) übereinander stapelbar ausgebildet ist und sich Durchtrittsöffnungen (127) für die Verbindungskontakte (114) im ersten Raster angeordnet von der Oberseite des Adapters (10) zu den Einführschlitzen (116) erstrecken.

15. Einbaubaugruppe nach einem der Ansprüche 1 bis 14, dadurch gekennzeichnet, daß der Adapter (10) von einem im Schnitt im wesentlichen L-förmigen Adapter (10') umgreifbar ist, dessen Rasterung derjenigen des Adapters (10) entspricht.

16. Einbaubaugruppe nach Anspruch 14 oder 15, dadurch gekennzeichnet, daß der Adapter (10) an seiner Oberseite eine Stufe (30, 125) aufweist, an der sich eine Schulter (31, 126) eines darüber gestapelten Adapters (10') abstützt.

17. Einbaubaugruppe nach einem der Ansprüche 1 bis 16, dadurch gekennzeichnet, daß der Adapter (10) Sollbruchstellen quer zu seiner Längsrichtung aufweist.

18. Einbaubaugruppe nach einem der Ansprüche 1 bis 17, dadurch gekennzeichnet, daß die Verbindungskontakte (18, 114) Füße (18a, 114e) zur Oberflächenmontierung auf der Leiterplatte (40, 117) und der Adapter (10) benachbart zu den Füßen (18a, 114e) einen sich praktisch über die gesamte Breite des Adapters erstreckenden Heißluftzuführungskanal (42) aufweist.

## Claims

A front panel built-in unit for a circuit board (40, 117), comprising a member (10) having contacts (13, 114) for connecting the member (10) to the printed circuit board (40, 117), said contacts being disposed in a first predetermined pattern, and comprising housings (26, 119) to receive function elements (21 to 25, 120), whose housing contacts (15, 121) are arranged in a second predetermined pattern and are detachably in engagement with the connecting contacts (18, 114) via contact connector pairs arranged in the second pattern, characterised in that the member is constructed as an adapter (10) and the connecting contacts (13, 114) are L-shaped and are supported in the adapter (10), against the direction of the action of the force from the printed circuit board (40, 117), by their limbs (114a), which are adapted to be brought into engagement with the housing contacts (15, 121), the housings (26, 119) being standardized in accordance with the second pattern and the connecting contacts (18, 114) being capable of introduction into the adapter (10) as required, the adapter having plug-in apertures (16, 113) disposed in accordance with the second pattern and receiving the limbs (114a) of the connecting contacts (18, 114) which form the contact connector pairs.

2. A built-in unit according to claim 1, characterised in that entry slots (116) for the connecting contacts (114) extend from the back of the adapter (10) inwards and from the base thereof upwards as far as the plug-in apertures (113).

3. A built-in unit according to claim 1 or 2, characterised in that abutment shoulders (110a) inwardly limiting the entry slots (116) form abutments for the limbs (114d) of the connecting contacts (114) extending towards the printed circuit board (117).

4. A built-in unit according to claim 1, characterised in that the adapter (10) has L-shaped ducts (16, 17) to receive the connecting contacts (18).

5. A built-in unit according to claim 4, characterised in that the adapter (10) is made up of at least two parts (10a, 10b, 10c), the parting line between the parts (10a, 10b, 10c) extending along the ducts (17) to receive the limb of the connecting contacts (13) extending towards the printed circuit board (40).

6. A built-in unit according to claim 4 or 5, characterised in that the ducts (17) in the adapter (10) are lengthened L-shape by ducts (29) terminating at the back of the adapter (10) in the pattern of the circuit board (40).

7. A built-in unit according to any one of claims 1 to 6, characterised in that the or each housing (26, 119) is made in one piece with the adapter (10).

8. A built-in unit according to any one of claims 1 to 6, characterised in that the housings (26, 119) can be secured on the adapter (10) by means of a releasable latching connection (11, 27; 11, 122).

9. A built-in unit according to claim 8, characterised in that the releasable latching connection (11, 27; 11, 122) consists of a spring tongue (27, 122) disposed at the back of the housing (26, 119) and a groove (11) which is disposed on the adapter (10) and into which the spring tongue (27, 122) is engageable.

10. A built-in unit according to claim 9, characterised in that the groove (11) extends in the longitudinal direction of the adapter (10) at the top thereof.

11. A built-in unit according to claim 9, characterised in that grooves (11) for engaging spring tongues (122) are disposed at regular intervals corresponding to the second pattern perpendicularly to the longitudinal direction of the adapter (10) so as to open out at the adapter (10) at the front.

12. A built-in unit according to any one of claims 1 to 11, characterised in that a device (20, 118) is provided for adjustment of the housings (26, 119) with respect to the adapter (10) in accordance with the second pattern.

13. A built-in unit according to any one of claims 8 to 12, characterised in that the releasable latching connection (11, 27; 11, 122) and the adjustment device (20, 118) are combined.

14. A built-in unit according to any one of claims 1 to 3 and 7 to 14, characterised in that the adapters (10) are stackable one above the other and passage apertures (127) for the connecting contacts (114) arranged in the first pattern extend from the top of the adapter (10) to the entry slots (116).

15. A built-in unit according to any one of claims 1 to 14, characterised in that an adapter (10') of substantially L-shape in section is adapted to engage around the adapter (10) and its pattern corresponds to that of the latter adapter.

16. A built-in unit according to claim 14 or 15, characterised in that the top of the adapter (10) has a step (30, 125) on which a shoulder (31, 126) of an adapter (10') stacked thereabove bears.

17. A built-in unit according to any one of claims 1 to 16, characterised in that the adapter (10) has predetermined breaking points transversely of its longitudinal direction.

18. A built-in unit according to any one of claims 1 to 17, characterised in that the connecting contacts (18, 114) have feet (18a, 114e) for surface mounting on the printed circuit board (40, 117) and the adapter (10) has adjacent the feet (18a, 114e) a hot-air supply duct (42) extending practically over the entire width of the adapter.

## Revendications

1. Module de montage sur panneau frontal pour une plaquette à circuits imprimés (40, 117) comprenant un support (10), les contacts de connexion (18, 114) pour la connexion du support (10) sur la plaquette (40, 117), contacts qui sont disposés selon une première configuration prédéterminée, ainsi que des boîtiers (26, 119) pour le logement d'éléments fonctionnels (21 à 25, 120), dont les contacts de boîtier (15, 121) sont disposés selon une deuxième configuration prédéterminée et qui sont en position de prise amovible avec les contacts de connexion (18, 114) par l'intermédiaire de contacteurs pouvant être enfichés disposés selon la deuxième configuration, caractérisé par le fait que le support est réalisé sous la forme d'un adaptateur (10) et que les contacts de connexion (18, 114) en forme de L s'appuient, à l'intérieur de l'adaptateur (10), par leurs broches (114a) pouvant être connectées avec les contacts de boîtier (15, 121) dans la direction opposée de la force exercée par la plaquette (40, 117), les boîtiers (26, 119) étant standardisés selon la deuxième configuration et les contacts de connexion (18, 114) pouvant être introduits selon les besoins dans l'adaptateur (10), ledit adaptateur (10) présentant des orifices d'enfichage (16, 113) disposés selon la deuxième configuration qui reçoivent les broches (114a) constituant les connecteurs des contacts de connexion (18, 114).

2. Module de montage selon la revendication 1, caractérisé par le fait que des fentes d'insertion (116) pour les contacts de connexion (114) s'étendent du côté arrière de l'adaptateur (10) vers l'intérieur et de son fond en direction du haut jusqu'aux orifices d'enfichage (113).

3. Module de montage selon la revendication 1 ou 2, caractérisé par le fait que les épaulements de butée (110a) qui délimitent vers l'intérieur les fentes d'insertion (116) constituent des butées pour les broches (114d) des contacts (114) broches qui s'étendent jusqu'à la plaquette (117).

4. Module de montage selon la revendication 1, caractérisé par le fait que l'adaptateur (10) présente des canaux (16, 17) en forme de L pour la réception des contacts de connexion (18).

5. Module de montage selon la revendication 4, caractérisé par le fait que l'adaptateur (10) est composé d'au moins deux parties (10a, 10b, 10c), la ligne de séparation entre lesdites parties (10a, 10b, 10c) s'étendant le long des canaux (17) pour la réception des broches s'étendant jusqu'à la plaquette (40) des contacts de connexion (18).

6. Module de montage selon la revendication 4 ou 5, caractérisé par le fait que les canaux (17) dans l'adaptateur (10) sont prolongés, en formant un L, par des canaux (29) qui aboutissent à la plaquette (40) sui le côté arrière de l'adaptateur (10).

7. Module de montage selon l'une des revendications 1 à 6, caractérisé par le fait que le ou les boîtiers (26, 119) sont réalisés de manière à ne former qu'une seule pièce avec l'adaptateur (10).

8. Module de montage selon l'une des revendications 1 à 6, caractérisé par le fait que les boîtiers (26, 119) peuvent être fixés sur l'adaptateur (10) au moyen d'un raccord amovible (11, 27; 11, 122) à saillie et encoche.

9. Module de montage selon la revendication 8, caractérisé par le fait que le raccord amovible (11, 27; 11, 122) à saillie et encoche est constitué d'une languette élastique (27, 122) disposée sur le côté arrière du boîtier (26, 119) et d'une rainure (11) disposée sur l'adaptateur (10) dans laquelle la languette (27, 122) peut venir s'encastrer.

10. Module de montage selon la revendication 9, caractérisé par le fait que la rainure (11) s'étend en direction longitudinale de l'adaptateur (10) sur le côté supérieur de celui-ci.

11. Module de montage selon la revendication 9, caractérisé par le fait que les rainures (11) pour l'encastrement de languettes (122) sont disposées à des distances régulières qui correspondent à la deuxième configuration, perpendiculairement à la direction longitudinale de l'adaptateur (10), de manière à déboucher du côté frontal sur ledit adaptateur (10).

12. Module de montage selon l'une des revendications 1 à 11, caractérisé par le fait qu'il est prévu un dispositif (20,118) pour ajuster le boîtier (26,119) par rapport à l'adaptateur (10) selon la deuxième configuration.

13. Module de montage selon l'une des revendications 8 à 12, caractérisé par le fait que le raccord amovible à saillie et encoche (11, 27; 11, 122) et le dispositif (20, 118) sont réunis en vue de l'ajustage.

14. Module de montage selon l'une des revendications 1 à 3 et 7 à 13, caractérisé par le fait que l'adaptateur (10) est réalisé de manière à pouvoir être empilé sur un autre adaptateur et que des orifices de passage (127) pour les contacts de connexion (114), disposés selon la première configuration, s'étendent du côté supérieur de l'adaptateur (10) jusqu'aux fentes d'insertion (116).

15. Module de montage selon l'une des revendications 1 à 14, caractérisé par le fait que l'adaptateur (10) peut être entouré par un adaptateur (10') de forme sensiblement en L vu en coupe, et dont la configuration des contacts correspond à celle de l'adaptateur (10).

16. Module de montage selon la revendication 14 ou 15, caractérisé par le fait que l'adaptateur (10) présente sur son côté supérieur un épaulement (30, 125) sur lequel s'appuie un épaulement (31, 126) d'un adaptateur (10) superposé sur l'adaptateur (10).

17. Module de montage selon l'une des revendications 1 à 16, caractérisé par le fait que l'adaptateur (10) présente, transversalement à sa direction longitudinale, des zones frangibles.

18. Module de montage selon l'une des revendications 1 à 17, caractérisé par le fait que les contacts de connexion (18, 114) sont munis de pattes (18a, 114e) pour le montage en surface sur la plaquette conductrice (40, 117) et que l'adaptateur (10), au voisinage des pattes (18a,114e), présente un canal (42) d'amenée d'air chaud s'étendant pratiquement sur toute la largeur de l'adaptateur.

Fig. 1

Fig. 2

Fig. 3

Fig. 4

1

Fig. 5

Fig. 7

Fig. 6

Fig. 8

Fig. 9

Fig. 10

Fig. 11

Fig. 12

Fig. 13

7

Fig. 14

Fig. 15

Fig. 16